# EUROPEAN PATENT SPECIFICATION

(11) **EP 2 735 544 B1**
(45) Date of publication and mention of the grant of the patent: **30.09.2020**
(21) Application number: 13194718.6
(22) Date of filing: 27.11.2013
(51) Int. Cl.: C01B 35/02, C23C 16/28, C23C 16/34, C23C 16/04, C23C 16/32, C23C 16/44, C23C 16/46, F16L 53/00, F16L 59/08, C04B 35/626, B01J 19/18, C01B 21/064, C01B 21/068, B01J 19/02, F16L 53/32, F16L 53/38

(54) **A reactor designed for chemical vapor deposition method and method of producing elemental boron and advanced ceramic powders with this reactor**
Für chemisches Dampfabscheidungsverfahren entworfener Reaktor und Verfahren zur Herstellung von elementarem Bor und erweiterter keramischer Pulver mit diesem Reaktor
Réacteur conçu pour procédé de dépôt chimique en phase vapeur, procédé de production de bore élémentaire et poudres céramiques avancées avec ce réacteur

(30) Priority: 27.11.2012 TR 201213720
(43) Date of publication of application: 28.05.2014
(73) Proprietor: Ulusal Bor Arastirma Enstitusu (Boren), 06520 Ankara (TR)
(72) Inventor: Duman, Ismail, Istanbul (TR); Agaogullari, Duygu, Istanbul (TR); Balci, Ozge, Istanbul (TR); Ovecoglu, Lufti, Istanbul (TR)
(74) Representative: Dericioglu, E. Korhan

(56) References cited:
- JP-A- H0 634 093
- JP-A- S62 292 607
- US-A- 6 042 370

## Description

### Field of the Invention

The invention relates to a reactor proper to the chemical vapor deposition method employed in production of elemental boron and advanced ceramic powders.

### Background of the Invention

There are many patents and reported research investigations in the archival literature about the production of elemental boron from gas phase. Various gas mixtures and processes are used in these studies.

In the United States patent documents no. US 1046043 and US 1074672, production of elemental boron via precipitation was performed from BC1₃ and H₂ gas mixtures by using glass or copper chamber heated with electrical arc. In these studies, boron was precipitated on the reactor walls and on the electrodes.

In the United States patent document no. US2542916, by delivering BC1₃ and H₂ gas mixtures to the tungsten wire electrically heated to 1400°C, boron deposition was achieved on the surface of the wire.

In the United States patent document no. US2839367, BCI3 and H₂ gas mixtures were delivered onto the titanium or zirconium filament heated to 1050-1150°C. It was stated that with this method, boron could be stripped from the surface or could be applied onto the surface as a protective coating. Since a dense boride layer was formed, recovery process was performed via physical separation (sink-float method) by using a suitable organic liquid (such as methylene dibromide).

After the boron coated filament was grounded and most of the iron, silicon, titanium and titanium boride impurities therein were separated, boron with a maximum purity of 99% was achieved. With the additional chlorination process performed at 300-400°C, volatile tetrachlorides of filament metals were produced and thereby purity enhancement was realized.

In the United States patent document no. US3086847, BCI3 gas was blown onto a sodium film which was formed by delivering liquid sodium onto a sodium chloride bed kept at 375°C. A part of this mixture was transferred into a stainless-steel tube under argon and it was heated in an electric furnace to 925°C for 2.5 hours. Crystalline boron and molten salt were broken up from the tube and leached with water. Boron of 94.8% purity was obtained.

In a publication made by Mierzejewska and Niemyski in 1966, BCI3 and H2 gas mixture was conveyed onto inductively heated graphite rods placed in quartz tubes. It was stated that in the experiments conducted at temperatures ranging from 1000 to 1600°C for 12 hours crystalline boron was deposited on the substrate surface. In this study, the most suitable boron trichloride flow rate was determined as 0.5-0.7 g/min. Furthermore, it was emphasized that purity of the precipitated boron powders directly depend on the purity of the boron trichloride that was used. *(*Mierzejewska S., Niemyski T., Vapour Growth of Boron Crystals, Journal of the Less-Common Metals, 10 (1966) 33-37.)

After a report published in 1969, partially a-rhombohedral structured amorphous boron powders were deposited from BCI3-H2 gas mixtures with a rate of 0.18 g/hour on glass and quartz filaments placed in a Pyrex tube and heated by copper electrodes. *(*Hultquist A.E., Sibert M.E., The Glow Discharge of Boron, Materials Science Laboratory, Lockheed Palo Alto Research Laboratory, Palo Alto, California, 1969, 161-178*.).*

In the United States patent document no. US3488152, elemental boron production was performed by mixing BCI3 and H2 gases in a controlled manner. By passing H2 gas through the BCI₃ gasification tank containing BCI₃ gas and liquid BCI3 together, the BCI3-H2 gas mixture was delivered to the boron production reactor (coaxial tubular reactor). The system was adjusted such that the volumetric ratio of the H2:BC_{I}3 gas mixture entering the reactor was 1:6. hi order to achieve this ratio, temperature of the gasification tank was maintained at an optimum value, and pressure of the BC1₃ gas was taken under control by adjusting the volume of the delivered H2 gas. In the reactor, on the metallic substrate electrically heated to 700-1400°C, a continuous filament of elemental boron was deposited.

In an article published in 1959, rhombohedral boron was produced by pyrolytic decomposition of BI3 gas on a tantalum surface heated to 800-1000°C. *(*Decker B.F., Kasper J.S., The Crystal Structure of a Simple Rhombohedral Form of Boron, Acta Crystallographies 12 (1959) 503-506*.)*

In the United States patent document no. US3053636, thermal decomposition of BBr₃-H₂ gas mixture on heated tantalum filament was investigated at temperatures ranging from 1125 to 1175°C and in a protective atmosphere formed with helium gas in a fused-silica tube. At 1125°C, a dendritic, amorphous-like, low temperature a-rhombohedral form of boron was deposited on the filament protected by tantalum diboride film. It was asserted that formation of tantalum diboride film reduced the reaction temperature about 150°C. In the case of exceeding 1200°C, the boron layer formed on the tantalum diboride film could not be stripped off. Thus, operation temperature was limited for obtaining boron powder. In the experiments conducted at temperatures below 950°C, boron formation became very slow and the boron stripped itself away from the surface, but no tantalum diboride layer was formed. It was stated that the boron deposited in the experiments carried out at temperatures below 950°C and above 1200°C contained impurities of Mg, Fe and Ta.

In the United States patent document no. US3115393, the BC1₃ and BBr₃ gas mixture and the reductive B2H6 gas were delivered to the Pyrex decomposition chamber which included tantalum wire (inert surface) and was heated by electric resistance at temperatures ranging from 800 to 1000 °C. Formation of solid boron hydride polymers on the walls was prevented by cooling the walls of the Pyrex chamber with circulating water. It was stated that the continuous boron layers depositing on the inert surface could be removed either mechanically or by means of etching or dissolving away the inert surface with a suitable acid (e.g. HF, HC1, etc.).

In the United States patent document no. US3226248, after passing of H₂ gas with a flow rate of 500 cm³/min at 1 atm pressure through liquid BBr3, the gas mixture (mole ratio of BBr3:H2=8:10) was heated at temperatures ranging from 727 to 1327°C and crystalline boron was obtained by delivering this mixture onto tungsten filament. Achieved boron contained impurities such as W2B and W2B5. A boron rod having a diameter of 4 mm could be produced in 100 minutes duration.

In an article published in 1973/74, the production of boron and boron carbide were performed by reducing BCI3 or BBr3 gases with H2 or CH4 in an induction furnace. In different experiments with BBr3 and BCI3 gases, it was observed that under the same initial conditions, BBr₃ gas worked at 100°C lower temperature. However, when the lower boron content, lower volatility and higher price of BBr3 than those of BCI3 were taken into consideration, this temperature difference was not very significant. It was indicated that at the molar ratio of H2/BC_{I}3=30/1 and at the temperature of 1300°C, boron trichloride was converted into elemental boron with a yield of 85%. It was determined that no reaction occurred between the tungsten substrate and boron deposits. It was observed that the reactivity between deposited boron and substrate material increases when graphite, fused silica, mullite, alumina, nickel and titanium were used. Considering that fused silica and mullite caused only small amounts of contamination, it was stated that the use of these materials were more suitable as substrates. *{*Donaldson J.G., Stephenson J.B., Cochran A.A., Boron and Boron Carbide by Vapor Deposition, Electrodeposition and Surface Treatment, 2 (1973/74) 149-163*.)*

In 1991, Allen and Ibrahim produced high purity metallic boron powders having spherical particles and narrow size distribution by means of chemical vapor deposition in a fluidized bed system at 500-600°C. B2H6 and/or B10H14 gas and H2 gas were mixed together and fed to the lower part of the reaction furnace, and from the top thereof, boron seed particles of 150-200 Ijm were charged. While the conveyed boron seed particles functioned as a kind of vapor adsorption surface, the gas enabled to precipitate on these particles and thus metallic boron larger than the delivered boron particles were produced. It was stated in the said study that the obtained metallic boron was at least 99.9995% pure. *(Allen R.H., Ibrahim J., Preparation of High Purity Boron, United States Patent, No:* 5013604*, 07.05.1991.)*

Japanese patent document no. JP2005183823 discloses substrate processing equipment that provides rapid temperature rise and fall. This batch hot-wall type CVD equipment has a process tube having an outer tube and an inner tube and constituting a process room for treating a wafer, a heat insulation bath that surrounds a process tube, a heat lamp group for heat wave radiation, a reflector for reflecting the heat waves of the heat lamp group towards the above process room, a cooling air path formed between the process tube and the heat insulation bath, multiple nozzles laid circumferentially to a cooling air path with equal spaces, multiple injection tips provided to each nozzle in a way that cooling air can be injected towards the outer tube, and outlets provided to the ceiling of the heat insulation bath.

Document US6042370 is also disclosing a CVD reactor.

In the above-exemplified previous techniques, in obtaining elemental boron from BCI3-H2 gas mixture by CVD (Chemical Vapor Deposition) method, outer surface of heated filaments or rods are used. Due to the mutual diffusion occurring between the substrate material and the deposited material, both the purity of the obtained material was deteriorated and a compact deposit, which is harder to separate from the substrate, was obtained instead of powder. The use of filaments such as zirconium, titanium, tungsten, tantalum, molybdenum, graphite, nickel, etc. as substrates caused formation of intermediate compounds such as boride or boron carbide phases as a layer between the substrate and the boron. Thus, the deposited boron served as a coating on the substrate material. In this case, the boron coated filament had to be subjected to a set of additional processes such as grinding, dissolving and chlorination (for removing the volatile impurities of the filament) in order to recover the boron. On the other hand, reducing the process temperature in order to precipitate boron powder that can be separated from the filament surface without formation of an intermediate compound reduces the boron deposition rate significantly.

If quartz filament is used in the reactor, impurities are not formed. However, when it is evaluated in terms of volume-time efficiency, it is observed that boron production rate significantly decreases. During the production from gas phase using electric arc furnace, boron precipitated on the reactor walls or on the electrodes.

The facts that the reaction zone (hot zone) is limited and that the temperature distribution is not homogenous are the major disadvantages of the methods applied in the art. On the other hand, amorphous and crystalline particles are present together in most of the commercially available boron powders. The reason for that is most probably the domination of a temperature gradient exhibiting a steep slope in the production reactors.

### Summary of the Invention

The primary objective of the present invention is to design a reactor for chemical vapor deposition method which enables homogenous temperature distribution in the reactor thanks to its reflector and minimizes the radiative energy losses to the surroundings and to produce elemental boron and advanced ceramic powders by means of this reactor.

Another objective of the present embodiment is to realize production processes for elemental boron and advanced ceramic powders utilizing this reactor, proper to chemical vapor deposition method, which enables the production of uniform and mono/multi-structured products in higher amounts than those yielded in conventional applications by means of the homogenous temperature distribution.

A further objective of the present embodiment is to realize production processes for elemental boron and advanced ceramic powders utilizing this reactor, proper to chemical vapor deposition method, which enables the deposition of the product throughout the inner wall of the quartz reactor and thus a significant avoidance of impurity formation in the product, instead of the deposition of the product obtained from within the gas mixture on a unit which forms an intermediate compound with boron such as heated filament or rod, during the flow of the gas mixture comprising the product through the reactor.

### Detailed Description of the Invention

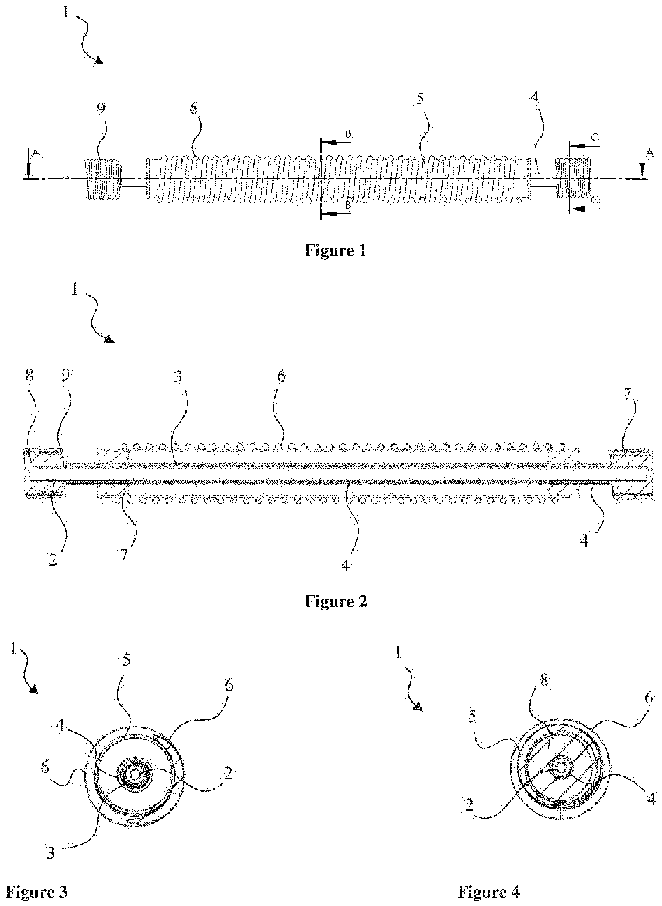

For the purposes of this disclosure, a reactor is an apparatus proper to chemical vapor deposition. Particularly, a reactor is an apparatus to produce elemental boron and advanced ceramic powders (B4C, BN, SiC and Si3N4). "A reactor proper to production of the elemental boron and advanced ceramic powders via chemical vapor deposition method " developed to fulfill the objective of the present invention are illustrated in the accompanying figures, wherein
Figure 1 is the side view of the inventive reactor design.
Figure 2 is the view of the A-A section shown in Figure 1.
Figure 3 is the view of the B-B section shown in Figure 1.
Figure 4 is the view of the C-C section shown in Figure 1.

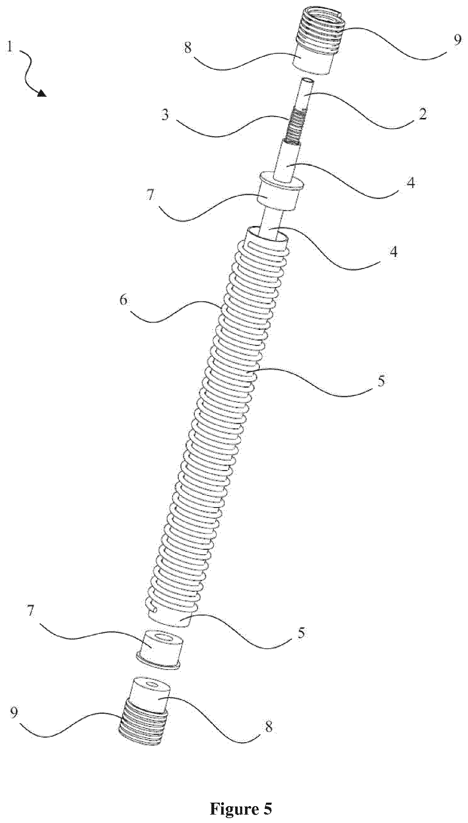

Figure 5 is the exploded view of the invented reactor design.

Reference numbers are assigned to the components shown in the figures as follows:
1. Reactor proper to chemical vapor deposition method
2. Inner tube
3. Heating elements
4. Outer tube
5. Reflector
6. Jacket
7. Stopper
8. End stopper
9. End jacket

The reactor used for the purpose of producing elemental boron and advanced ceramic powders using chemical vapor deposition method basically comprises:
- at least one inner tube (2), through which the gas flow including the component to be precipitated by heat is passed,
- at least one heating element (3) which surrounds the inner tube (2) and enables to heat both the inner tube (2) and the gas passing therethrough,
- at least one outer tube (4) which encompasses the inner tube (2) and the heating element (3) such that it encloses them,
- at least one reflector (5) which encompasses the outer tube (4) and whose surface facing the outer tube (4) is reflective,
- at least one jacket (6) which surrounds the reflector (5) as a continuous second wall or is in the shape of a spiral through which the coolant fluid passes,
- at least one stopper (7) which protects the distance between the reflector (5) and the outer tuba (4), which clogs the openings of the reflector (5) and which prevents heat escape from the open ends of the reflector (5).

In the invention, the inner tube (2) is produced from the quartz material since it leaves behind only Si containing particles, which can be easily removed as impurity during purification of the elemental boron and advanced ceramic powders deposited on the inner surface of the tube.

In the preferred embodiment of the invention, the outer tube (4) is produced from quartz material in order to form a transparent and heat resistant envelope which enables the thermal radiation emitted from the resistance to reach the reflector without any dissipation due to convection and to be reflected back to the inner tube.

In the preferred embodiment of the invention, resistance wires are used as the heating element (3) for heating the inner tube (2).

In another embodiment of the invention, resistances such as silicon carbide, molybdenum disilicide, etc., which are in the form of rods that can be heated to 1400°C and above, and which are in contact with the inner tube (2) for heating the inner tube (2) are used as the heating element (3).

In another embodiment of the invention, a heating fluid flowing between the inner tube (2) and the outer tube (4) is used as the heating element (3) for heating the inner tube (2).

In the preferred embodiment of the invention, the inner tube (2), the outer tube (4) wrapping the inner tube (2) and the reflector (5) wrapping the outer tube (4) are in the form of linear, concentric and co-axial cylinders in order to increase the inner tube (2) surface area on which the reaction takes place and to ensure homogenous temperature distribution.

In another embodiment of the invention, the inner tube (2), the outer tube (4) wrapping the inner tube (2) and the reflector (5) wrapping the outer tube (4) are manufactured to have spiral shapes in order to increase the inner tube (2) surface area on which the reaction takes place.

In another embodiment of the invention, with the purpose of increasing the reaction area, multiple number of inner tubes (2), in contact with each other and through which the same gas flows, are bunched.

In the preferred embodiment of the invention, non-metallic or metallic tubes made of titanium, steel, nickel coated steel, nickel or other metals with melting points above 1400°C or whose inner surfaces are coated with metal are used as the reflector (5) in order not to require cooling.

In the preferred embodiment of the invention, the stoppers (7) which are squeezed to the ends of the reflector (5) with the purpose of suspending the reflector (5) around the quartz tubes are made of fiber plates, kieselguhr bricks or similar refractory materials.

In another embodiment of the invention, non-metallic or metallic tubes made of metals such as aluminum, copper, etc. with melting points below 1400°C or whose inner surfaces are coated with metal are used as the reflector (5).

In the preferred embodiment of the invention, the end stoppers (8) clutching the ends of the inner tube (2) from outside are produced from teflon or a similar heat resistant polymer and these stoppers (8) are cooled from outside with the end jacket (9).

In another embodiment of the invention, the end stoppers (8) are quartz standard taper joints which do not require cooling.

In another embodiment of the invention, without using the end stoppers (8), both openings of the reaction inner tube (2) can be narrowed and gas charge and exhaust discharge tubes/hoses made of polymer material can be fitted over the tube.

In the invented reactor system (1) proper to chemical vapor deposition method, when homogenous gas mixtures are prepared and a sufficient amount is fed, temperature gradient is not formed throughout the reactor system (1); a homogenous temperature distribution is provided. The components within the gas mixture prepared in cold environment rapidly diffuse into one another with a sudden expansion as soon as they enter the inner tube (2) of the invented reactor system (1), and the powders with controllable particle size are deposited along the inner wall of the inner tube (2).

In the invented reactor system (1), the quartz inner tube (2) wrapped with the heating elements (3) is enclosed by another quartz outer tube (4) and a reflector (5) which is produced from a material that reflects heat is fitted over the outer tube at full length. Temperature of the inner tube (2) wherein the reaction takes place is provided by the heating elements (3) which can be made of resistance wire or rods heated to elevated temperatures. The heat emitted by radiation from the heating element (3) provided between the nested inner tube (2) and outer tube (4), is reflected back to the central axis of the inner tube (2) using a cylindrical reflector (5). By means of the homogenous temperature distribution achieved on the entire inner surface of the quartz inner tube (2), the material deposited from gas phase is in powder form rather than coherent massive form. At the same time, through this homogenous temperature distribution obtained in the inner tube (2), deposition can occur on the entire inner wall of the reaction tube. In the invented reactor, the use of a reflector (5) significantly reduces the energy consumption required for providing the desired temperature.

Surface temperature of the inner tube (2) made of quartz material is provided by the hot resistance wires wrapping the inner tube (2). The resistance wires that are used as heating elements (3) are wrapped around the inner tube (2) used as the reaction surface, in a spiral form. The quartz inner tube (2) can also be heated by resistances such as silicon carbide, molybdenum disilicide, etc., which are in the form of a rod that can be used at 1400°C and above, instead of heating by the resistance wires wrapped on it in a spiral form. The temperature in the inner tube (2) provided by the heating element (3) is adjusted by a variable transformer. By means of the heating elements which are able to reach temperatures of 1400°C and above, it can be worked at different temperatures in the system.

The quartz inner tube (2) wrapped with the heating elements (3) is enclosed by another quartz outer tube (4), and a tube which is produced from a material that reflects heat, i.e. a reflector (5), is fitted over the outer tube. The purpose for using a reflector (5) is to turn back the heat emitted from the resistances used as the heating elements (3) towards the inner tube (2) in accordance with the concave mirror principle, to focus the heat towards the central axis of the inner tube (2) and to provide a dense medium at a homogenous temperature within the inner tube (2). The reaction product is discharged as a powder collective in the form of non-adherent solid particles from the surface of the quartz tube (2) used as the reaction surface.

In the designed reactor (1), the reaction zone can be extended as desired and higher amounts of elemental boron and advanced ceramic powders can be obtained in a unit of time. Enhancing the reaction efficiency is possible by optimization of the reactor diameter/length ratio.

Differing from the known Chemical Vapor Deposition (CVD) applications, the reactor design (1) of the present invention enables using the inner surface of the inner tube (2) as the substrate material; providing homogenous temperature distribution throughout the inner tube (2) and accordingly forming a large precipitation surface at even temperature; and obtaining the precipitated powders in free/pure form.

Elemental boron and advanced ceramic powders production carried out in the invented reactor is based on chemical vapor deposition (CVD) performed by deposition/precipitation of the gas mixtures on the hot quartz surface via thermal dissociation of them. In this method, the gas mixtures are prepared and delivered by pumping or by their own pressures into the inner tube (2) which acts as a hot reaction medium. While elemental boron and advanced ceramic powders precipitate in the form of solid particles or layers via thermal dissociation and reduction on the inner tube (2) surface which forms the hot substrate thanks to the structure of the reactor system (1), the residual waste gases remaining after the reaction are discharged through the other end of the reactor. Since the boron and advanced ceramic powders holding on to the inner surface of the quartz inner tube (2) do not form an adherent layer, they can be easily stripped from the substrate by physical methods. The resultant powder is only contaminated by some silicon partially reduced from the quartz inner tube (2). Silicon containing particles can be completely removed from the product via leaching with hydrofluoric acid (HF). If there is unpurged oxygen within the inner tube (2), the boron powder may be also contaminated with some B₂O₃. As soon as this oxygen bearing component enters into the solution during HF leach, it is easily eliminated. Thus high-purity elemental boron and advanced ceramic powders are obtained.

The invented reactor system (1) provides both a more efficient production of elemental boron and advanced ceramic powders and purer products with loose particles. In the invented reactor design (1), elemental boron and advanced ceramic powders can be precipitated throughout the inner surface of the quartz inner tube (2). In the studies conducted on elemental boron production, any boride or silicide phases formed by the interaction of the quartz inner tube (2) and the boron powders are not encountered. The use of quartz inner tube (2) as the substrate material provides a solution for the problems of boride formation and substrate-precipitate separation experienced in boron production via reduction from gas phase. The thermal radiation emitted by the heating element (3) is completely reflected back to the central axis throughout the inner tube (2) and the outer tube (4) by the help of the reflector (5) (by using a metal tube, whose inner surface is polished, as a concave mirror). This way, a precipitation surface is formed on a large area which includes the entire length of the reaction inner tube (2) and the entire inner wall of the inner tube (2). Homogenous temperature distribution is provided in the inner tube (2) used as the reaction medium and the boron powders nucleate on the hot surface and on one another throughout the inner tube (2) (such that almost the whole cross-section of the inner tube (2) is filled). Whereas 1 unit of energy is used in a unit of time in the Chemical Vapor Deposition processes performed without employing a reflector (5), 1/4.5 unit of energy is spent when a reflector (5) is employed.

## Claims

1. A reactor (1) proper to production of boron and advanced ceramic powders via chemical vapor deposition method, which is used for the purpose of producing elemental boron and advanced ceramic powders with chemical vapor deposition method and basically **comprises the following elements**
- at least one inner tube (2), through which the gas including the component to be precipitated by heat is passed and said inner tube (2) is produced from quartz material due to the fact that elemental boron and advanced ceramic powders deposited on the inner surface thereof include only Si containing particles as impurity which can be easily removed at the purification step.,
- at least one heating element (3) which surrounds the inner tube (2) and enables to heat both the inner tube (2) and the gas passing therethrough,
- at least one outer tube (4) which encompasses the inner tube (2) and the heating element (3) such that it encloses them,
- at least one reflector (5) which encompasses the outer tube (4) and whose surface facing the outer tube (4) is reflective,
- at least one jacket (6) which surrounds the reflector (5) as a continuous second wall or is in the shape of a spiral through which the coolant fluid passes,
- at least one stopper (7) which protects the distance between the reflector (5) and the outer tube (4), which clogs the openings of the reflector (5) and which prevents heat escape from the open ends of the reflector (5).

2. A reactor (1) proper to production of boron and advanced ceramic powders via chemical vapor deposition method according to Claim 1, comprising the outer tube (4) which is produced from quartz material in order to form a transparent and heat resistant envelope which enables the thermal radiation emitted from the resistance to reach the reflector without any dissipation due to convection and to be reflected back to the central axis of the inner tube (2).

3. A reactor (1) proper to production of boron and advanced ceramic powders via chemical vapor deposition method according to any one of the preceding claims, comprising at least one heating element (3) which is a resistance wire.

4. A reactor (1) proper to production of boron and advanced ceramic powders via chemical vapor deposition method according to any one of Claims 1 or 2, comprising at least one heating element (3) which is in contact with the inner tube (2) and which is a resistance such as silicon carbide, molybdenum disilicide, etc. that are in the form of rods that can resist to temperatures of 1400°C and above.

5. A reactor (1) proper to production of boron and advanced ceramic powders via chemical vapor deposition method according to any one of Claims 1 to 2, comprising at least one heating element (3) wherein a hot fluid flows between the inner tube (2) and the outer tube (4) is used.

6. A reactor (1) proper to production of boron and advanced ceramic powders via chemical vapor deposition method according to any one of the preceding claims, comprising at least one inner tube (2), at least one outer tube (4) wrapping the inner tube (2) and at least one reflector (5) wrapping the outer tube (4), which are in the form of linear, concentric and co-axial cylinders, in order to ensure homogenous temperature distribution and to increase the inner tube (2) surface area where the reaction takes place.

7. A reactor (1) proper to production of boron and advanced ceramic powders via chemical vapor deposition method according to any one of Claims 1 to 5, comprising at least one inner tube (2), at least one outer tube (4) wrapping the inner tube (2) and at least one reflector wrapping the outer tube (4) which are in the form of spirals in order to increase the inner tube (2) surface area where the reaction takes place.

8. A reactor (1) proper to production of boron and advanced ceramic powders via chemical vapor deposition method according to any one of the preceding claims, comprising at least two inner tubes (2) which are in contact with each other and through which the same gas flows with the purpose of increasing the reaction area.

9. A reactor (1) proper to production of boron and advanced ceramic powders via chemical vapor deposition method according to any one of the preceding claims, comprising at least one reflector (5) comprised of a non-metallic or metallic tube, which is made of titanium, steel, nickel coated steel, nickel or other metals with melting points above 1400°C or whose inner surface is coated with metal, in order not to require cooling.

10. A reactor (1) proper to production of boron and advanced ceramic powders via chemical vapor deposition method according to any one of Claims 1 to 8, comprising at least one reflector (5) comprised of a non-metallic or metallic tube, which is made of metals such as aluminum, copper, etc. with melting points below 1400°C or whose inner surface is coated with metal, with need of cooling.

11. A reactor (1) proper to production of boron and advanced ceramic powders via chemical vapor deposition method according to any one of Claims 1 to 8, comprising at least one reflector (5) which is formed by a metal tube or a nonmetal tube whose inner surface is coated with metal, and which is surrounded by a jacket (6) as a continuous second wall or in the shape of a spiral through which the coolant fluid flows.

12. A reactor (1) proper to production of boron and advanced ceramic powders via chemical vapor deposition method according to any one of the preceding claims, comprising at least one stopper (7), which is squeezed to the ends of the reflector (5) with the purpose of suspending the reflector (5) around the quartz tubes, and is made of fiber plates, kieselguhr bricks or similar refractory materials.

13. A reactor (1) proper to production of boron and advanced ceramic powders via chemical vapor deposition method according to any one of Claims 10 to 11, comprising at least one end stopper (8) which clutches the end of the inner tube (2) from outside, is produced from teflon or a similar heat resistant polymer, and is cooled from outside with a spiral end jacket (9).

14. A reactor (1) proper to production of boron and advanced ceramic powders via chemical vapor deposition method according to any one of Claims 10 to 11, comprising at least one end stopper (8) which is quartz standard taper joint without need of cooling instead of teflon or similar materials with external cooling.

15. A reactor (1) proper to production of boron and advanced ceramic powders via chemical vapor deposition method according to any one of Claims 10 to 11, comprising at least one inner tube (2) whose both openings are narrowed and gas charge and exhaust discharge tubes/hoses made of polymer material are fitted over the tube without using end stoppers (8).

## Patentansprüche

1. Reaktor (1) zur Herstellung von Bor- und hochentwickelten Keramikpulvern mittels chemischer Gasphasenabscheidung, der zum Zweck der Herstellung von elementarem Bor- und hochentwickelten Keramikpulvern mittels chemisches Bedampfungsverfahren verwendet wird und im wesentlichen **die folgenden Elemente umfasst**
- mindestens ein Innenrohr (2), durch das das Gas einschließlich der durch Wärme auszufällenden Komponente geleitet wird, und das Innenrohr (2) aus Quarzmaterial hergestellt ist aufgrund der Tatsache, dass elementares Bor- und hochentwickelte Keramikpulver, die auf seiner inneren Oberfläche abgeschieden sind, nur Si enthaltende Partikel als Verunreinigung enthalten, die in der Reinigungsstufe leicht entfernt werden können,
- mindestens ein Heizelement (3), das das Innenrohr (2) umgibt und es ermöglicht, sowohl das Innenrohr (2) als auch das durch dieses hindurchtretende Gas zu erwärmen,
- mindestens ein Außenrohr (4), das das Innenrohr (2) und das Heizelement (3) umfasst, sodass es diese umschließt,
- mindestens ein Reflektor (5), das das Außenrohr (4) umfasst und dessen dem Außenrohr (4) zugewandte Oberfläche reflektiv ist,
- mindestens eine Hülse (6), die den Reflektor (5) als eine kontinuierliche zweite Wand umgibt, oder die eine Spiralform aufweist, durch der das Kühlfluid strömt,
- mindestens ein Stopper (7), der den Abstand zwischen dem Reflektor (5) und dem Außenrohr (4) bewahrt, der die Öffnungen des Reflektors (5) verstopft und der das Entweichen von Wärme aus den offenen Enden des Reflektors (5) verhindert.

2. Reaktor (1) zur Herstellung von Bor- und hochentwickelten Keramikpulvern mittels chemisches Bedampfungsverfahren nach Anspruch 1, umfassend das Außenrohr (4), das aus Quarzmaterial hergestellt ist, um eine transparente und hitzebeständige Umhüllung zu bilden, die es ermöglicht, dass die vom Widerstand emittierte Wärmestrahlung ohne jegliche Dissipation durch Konvektion zum Reflektor gelangt und zur Mittelachse des Innenrohrs (2) zurückreflektiert wird.

3. Reaktor (1) zur Herstellung von Bor- und hochentwickelten Keramikpulvern mittels chemisches Bedampfungsverfahren nach einem der hervorstehenden Ansprüche, umfassend mindestens ein Heizelement (3), das ein Widerstandsdraht ist.

4. Reaktor (1) zur Herstellung von Bor- und hochentwickelten Keramikpulvern mittels chemisches Bedampfungsverfahren nach einem der Ansprüche 1 oder 2, umfassend mindestens ein Heizelement (3), das in Kontakt mit dem Innenrohr (2) ist und und bei das es sich um einen Widerstand wie Siliziumkarbid, Molybdändisilizid usw. handelt, die in Form von Stäben, die Temperaturen von 1400 °C und mehr standhalten können, vorliegen.

5. Reaktor (1) zur Herstellung von Bor- und hochentwickelten Keramikpulvern mittels chemisches Bedampfungsverfahren nach einem der Ansprüche 1 bis 2, umfassend mindestens ein Heizelement (3), wobei ein heißes Fluid, das zwischen das Innenrohr (2) und das Außenrohr (4) strömt, verwendet wird.

6. Reaktor (1) zur Herstellung von Bor- und hochentwickelten Keramikpulvern mittels chemisches Bedampfungsverfahren nach einem der hervorstehenden Ansprüche, umfassend mindestens ein Innenrohr (2), mindestens ein das Innenrohr (2) umhüllendes Außenrohr (4) und mindestens ein das Außenrohr (4) umhüllendes Reflektor (5), die die Form von linearen, konzentrischen und koaxialen Zylindern haben, um eine homogene Temperaturverteilung zu gewährleisten und die Oberfläche des Innenrohrs (2), wo die Reaktion stattfindet, zu vergrößern.

7. Reaktor (1) zur Herstellung von Bor- und hochentwickelten Keramikpulvern mittels chemisches Bedampfungsverfahren nach einem der Ansprüche 1 bis 5, umfassend mindestens ein Innenrohr (2), mindestens ein das Innenrohr (2) umhüllendes Außenrohr (4) und mindestens ein das Außenrohr (4) umhüllendes Reflektor, die die Form von Spiralen haben, um die Oberfläche des Innenrohrs (2), wo die Reaktion stattfindet, zu vergrößern.

8. Reaktor (1) zur Herstellung von Bor- und hochentwickelten Keramikpulvern mittels chemisches Bedampfungsverfahren nach einem der hervorstehenden Ansprüche, umfassend mindestens zwei Innenrohre (2), die miteinander in Kontakt stehen und durch denen das gleiche Gas durchströmt, um den Reaktionsbereich zu vergrößern.

9. Reaktor (1) zur Herstellung von Bor- und hochentwickelten Keramikpulvern mittels chemisches Bedampfungsverfahren nach einem der hervorstehenden Ansprüche, umfassend mindestens einen Reflektor (5), der aus einem nichtmetallischen oder metallischen Rohr besteht, das aus Titan, Stahl, mit Nickel beschichtetem Stahl, Nickel oder anderen Metallen mit Schmelzpunkten über 1400 °C hergestellt ist oder dessen Innenfläche mit Metall beschichtet ist, um keine Kühlung zu erfordern.

10. Reaktor (1) zur Herstellung von Bor- und hochentwickelten Keramikpulvern mittels chemisches Bedampfungsverfahren nach einem der Ansprüche 1 bis 8, umfassend mindestens einen Reflektor (5), der aus einem nichtmetallischen oder metallischen Rohr besteht, das aus Aluminium, Kupfer usw. mit Schmelzpunkten unter 1400 °C hergestellt ist oder dessen Innenfläche mit Metall beschichtet ist, wobei eine Kühlung erforderlich ist.

11. Reaktor (1) zur Herstellung von Bor- und hochentwickelten Keramikpulvern mittels chemisches Bedampfungsverfahren nach einem der Ansprüche 1 bis 8, umfassend mindestens einen Reflektor (5), der durch ein Metallrohr oder ein Nichtmetallrohr gebildet ist, dessen Innenfläche mit Metall beschichtet ist, und der von einem Hülse (6) als durchgehende zweite Wand oder in Form einer Spirale umgeben ist, durch die das Kühlfluid strömt.

12. Reaktor (1) zur Herstellung von Bor- und hochentwickelten Keramikpulvern mittels chemisches Bedampfungsverfahren nach einem der hervorstehenden Ansprüche, umfassend mindestens einen Stopper (7), der an die Enden des Reflektors (5) gequetscht wird, um den Reflektor (5) um die Quarzrohre herum aufzuhängen, und der aus Faserplatten, Kieselgursteinen oder ähnlichen feuerfesten Materialien besteht.

13. Reaktor (1) zur Herstellung von Bor- und hochentwickelten Keramikpulvern mittels chemisches Bedampfungsverfahren nach einem der Ansprüche 10 bis 11, umfassend mindestens ein Endstopper (8), der das Ende des Innenrohrs (2) von außen umgreift, aus Teflon oder einem ähnlichen hitzebeständigen Polymer hergestellt ist und von außen mit einer spiralförmigen Endhülse (9) gekühlt wird.

14. Reaktor (1) zur Herstellung von Bor- und hochentwickelten Keramikpulvern mittels chemisches Bedampfungsverfahren nach einem der Ansprüche 10 bis 11, umfassend mindestens einen Endstopper (8), bei dem es sich um eine Standard-Kegelverbindung aus Quarz ohne Kühlungsbedarf anstelle von Teflon oder ähnlichen Materialien mit externer Kühlung handelt.

15. Reaktor (1) zur Herstellung von Bor- und hochentwickelten Keramik pulvern mittels chemisches Bedampfungsverfahren nach einem der Ansprüche 10 bis 11, umfassend mindestens ein Innenrohr (2), dessen beide Öffnungen verengt sind, und Gasfüll- und Abgasentladungsrohre/-schläuche aus Polymermaterial sind ohne Verwendung von Endstopper (8) über dem Rohr angebracht.

## Revendications

1. Réacteur (1) propre à la production de bore et de poudres céramiques avancées par la méthode de dépôt chimique en phase vapeur, qui est utilisé dans le but de produire du bore élémentaire et des poudres céramiques avancées par la méthode de dépôt chimique en phase vapeur et qui **comprend essentiellement les éléments suivants**
- au moins un tube intérieur (2), par lequel passe le gaz, y compris le composant devant être précipité par la chaleur, et ledit tube intérieur (2) est produit à partir d'un matériau de quartz en raison du fait que le bore élémentaire et les poudres céramiques avancées déposées sur la surface intérieure de celui-ci ne comprennent que des particules contenant du Si comme impureté qui peuvent être facilement éliminées à l'étape de purification,
- au moins un élément chauffant (3) qui entoure le tube intérieur (2) et permet de chauffer à la fois le tube intérieur (2) et le gaz qui le traverse,
- au moins un tube extérieur (4) qui entoure le tube intérieur (2) et l'élément chauffant (3) de telle sorte qu'il les enferme,
- au moins un réflecteur (5) qui entoure le tube extérieur (4) et dont la surface tournée vers le tube extérieur (4) est réfléchissante,
- au moins une enveloppe (6) qui entoure le réflecteur (5) comme une deuxième paroi continue ou qui a la forme d'une spirale à travers laquelle passe le liquide de refroidissement,
- au moins un bouchon (7) qui protège la distance entre le réflecteur (5) et le tube extérieur (4), qui obstrue les ouvertures du réflecteur (5) et qui empêche la chaleur de s'échapper par les extrémités ouvertes du réflecteur (5).

2. Réacteur (1) propre à la production de bore et de poudres céramiques avancées par la méthode de dépôt chimique en phase vapeur selon la revendication 1, comprenant le tube extérieur (4) qui est fabriqué à partir de matériau de quartz afin de former une enveloppe transparente et résistante à la chaleur qui permet au rayonnement thermique émis par la résistance d'atteindre le réflecteur sans aucune dissipation due à la convection et d'être renvoyé vers l'axe central du tube intérieur (2).

3. Réacteur (1) propre à la production de bore et de poudres céramiques avancées par la méthode de dépôt chimique en phase vapeur selon l'une quelconque des revendications, comprenant au moins un élément chauffant (3) qui est un fil chauffant.

4. Réacteur (1) propre à la production de bore et de poudres céramiques avancées par la méthode de dépôt chimique en phase vapeur selon l'un quelconque des revendications 1 ou 2, comprenant au moins un élément chauffant (3) qui est en contact avec le tube intérieur (2) et qui est une résistance comme le carbure de silicium, le disilicide de molybdène, etc. qui se présentent sous la forme de tiges pouvant résister à des températures de 1400°C et plus.

5. Réacteur (1) propre à la production de bore et de poudres céramiques avancées par la méthode de dépôt chimique en phase vapeur selon l'un quelconque des revendications 1 à 2, comprenant au moins un élément chauffant (3) dans lequel un fluide chaud circule entre le tube intérieur (2) et le tube extérieur (4) est utilisé.

6. Réacteur (1) propre à la production de bore et de poudres céramiques avancées par la méthode de dépôt chimique en phase vapeur selon l'une quelconque des revendications, comprenant au moins un tube intérieur (2), au moins un tube extérieur (4) enveloppant le tube intérieur (2) et au moins un réflecteur (5) enveloppant le tube extérieur (4), qui se présentent sous la forme de cylindres linéaires, concentriques et coaxiaux, afin d'assurer une distribution homogène de la température et d'augmenter la surface du tube intérieur (2) où la réaction a lieu.

7. Réacteur (1) propre à la production de bore et de poudres céramiques avancées par la méthode de dépôt chimique en phase vapeur selon l'un quelconque des revendications 1 à 5, comprenant au moins un tube intérieur (2), au moins un tube extérieur (4) enveloppant le tube intérieur (2) et au moins un réflecteur enveloppant le tube extérieur (4) qui sont en forme de spirales afin d'augmenter la surface du tube intérieur (2) où la réaction a lieu.

8. Réacteur (1) propre à la production de bore et de poudres céramiques avancées par la méthode de dépôt chimique en phase vapeur selon l'une quelconque des revendications, comprenant au moins deux tubes intérieurs (2) qui sont en contact l'un avec l'autre et dans lesquels circule le même gaz dans le but d'augmenter la surface de réaction.

9. Réacteur (1) propre à la production de bore et de poudres céramiques avancées par la méthode de dépôt chimique en phase vapeur selon l'une quelconque des revendications, comprenant au moins un réflecteur (5) constitué d'un tube non métallique ou métallique, qui est en titane, en acier, en acier nickelé, en nickel ou en d'autres métaux ayant un point de fusion supérieur à 1400°C ou dont la surface intérieure est revêtue de métal, afin de ne pas nécessiter de refroidissement.

10. Réacteur (1) propre à la production de bore et de poudres céramiques avancées par la méthode de dépôt chimique en phase vapeur selon l'un quelconque des revendications 1 à 8, comprenant au moins un réflecteur (5) constitué d'un tube non métallique ou métallique, qui est fait de métaux tels que l'aluminium, le cuivre, etc. ayant un point de fusion inférieur à 1400°C ou dont la surface intérieure est revêtue de métal, avec nécessité de refroidissement.

11. Réacteur (1) propre à la production de bore et de poudres céramiques avancées par la méthode de dépôt chimique en phase vapeur selon l'un quelconque des revendications 1 à 8, comprenant au moins un réflecteur (5) qui est formé par un tube métallique ou un tube non métallique dont la surface intérieure est revêtue de métal, et qui est entouré d'une enveloppe (6) comme deuxième paroi continue ou sous la forme d'une spirale à travers laquelle circule le fluide de refroidissement.

12. Réacteur (1) propre à la production de bore et de poudres céramiques avancées par la méthode de dépôt chimique en phase vapeur selon l'une quelconque des revendications, comprenant au moins un bouchon (7), qui est pressé aux extrémités du réflecteur (5) dans le but de suspendre le réflecteur (5) autour des tubes de quartz, et est constitué de plaques de fibres, de briques de kieselguhr ou de matériaux réfractaires similaires.

13. Réacteur (1) propre à la production de bore et de poudres céramiques avancées par la méthode de dépôt chimique en phase vapeur selon l'un quelconque des revendications 10 à 11, comprenant au moins un bouchon d'extrémité (8) qui enserre l'extrémité du tube intérieur (2) depuis l'extérieur, est fabriqué en téflon ou en un polymère similaire résistant à la chaleur, et est refroidi depuis l'extérieur par une enveloppe d'extrémité en spirale (9).

14. Réacteur (1) propre à la production de bore et de poudres céramiques avancées par la méthode de dépôt chimique en phase vapeur selon l'un quelconque des revendications 10 à 11, comprenant au moins un bouchon d'extrémité (8) qui est un joint conique standard en quartz sans besoin de refroidissement au lieu du téflon ou de matériaux similaires avec refroidissement externe.

15. Réacteur (1) propre à la production de bore et de poudres céramiques avancées par la méthode de dépôt chimique en phase vapeur selon l'un quelconque des revendications 10 à 11, comprenant au moins un tube intérieur (2) dont les deux ouvertures sont rétrécies et des tubes/tuyaux de charge et de décharge de gaz en matériau polymère sont montés sur le tube sans utiliser de bouchons d'extrémité (8).
